(19)

Europäisches
Patentamt
European
Patent Office
Office européen
des brevets

(11) **EP 2 594 425 A1**

(12) **EUROPEAN PATENT APPLICATION**
published in accordance with Art. 153(4) EPC

(43) Date of publication:
**22.05.2013 Bulletin 2013/21**

(21) Application number: **11806957.4**

(22) Date of filing: **09.02.2011**

(51) Int Cl.:
**B60L 5/00** (2006.01)   **H02J 7/00** (2006.01)
**H02J 17/00** (2006.01)   **B60L 11/18** (2006.01)

(86) International application number:
**PCT/KR2011/000867**

(87) International publication number:
**WO 2012/008672 (19.01.2012 Gazette 2012/03)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **15.07.2010   KR 20100068470**

(71) Applicant: **Korea Advanced Institute of Science
and Technology
Daejeon 305-701 (KR)**

(72) Inventors:
• **SUH, Nam-Pyo
Daejeon 305-701 (KR)**

• **CHO, Dong-Ho
Seoul 137-072 (KR)**
• **RIM, Chun-Taek
Daejeon 305-701 (KR)**
• **JEON, Seong-Jeub
Busan 612-750 (KR)**
• **KIM, Jung-Ho
Daejeon 305-701 (KR)**
• **AHN, Seung-Young
Seoul 137-951 (KR)**

(74) Representative: **Hutter, Jacobus Johannes
Nederlandsch Octrooibureau
J.W. Frisolaan 13
2517 LS Den Haag (NL)**

(54) **METHOD AND DEVICE FOR DESIGNING A CURRENT SUPPLY AND COLLECTION DEVICE
FOR A TRANSPORTATION SYSTEM USING AN ELECTRIC VEHICLE**

(57)   Provided is a method for designing a current
supply device for wirelessly supplying power to a vehicle
having a current collection device. In the design method,
the gap between two adjacent magnetic poles of the cur-
rent supply device is received as input and then the gap
between the current supply device and the current col-
lection device is determined based on the gap between
the two magnetic poles. Next, the magnitude of the power
to be supplied to the current supply device is determined
based on the value required with respect to the magnitude of the magnetic field and the gap between the current supply device and the current collection device. Ac-
cording to the design method, current supply devices can
easily be designed since various functional requirements
are decoupled from each other.

FIG. 4

EP 2 594 425 A1

**Description**

Technical Field

The present invention relates to a method and device for designing a current supply and collection device for a transportation system using an electric vehicle, and more particularly, to a method and device for designing a current collection device to be installed in a vehicle and a current supply device for a transportation system using an electric vehicle capable of charging a battery and moving using power supplied from an external source simultaneously while moving.

Background Art

A conventional internal combustion engine vehicle is driven using fossil fuels. In this instance, exhaust gas emitted to an outside of the vehicle after the fossil fuels are combusted in an engine may cause environmental issues, for example, air pollution, global warming, and the like. In order to resolve such issues, research on vehicles using alternative energies has been conducted. Vehicles using the alternative energies may include a vehicle using electricity stored in a battery, a vehicle using a fuel cell consisting of hydrogen and oxygen, a vehicle using solar energy, and the like. Among the vehicles mentioned above, the vehicle using electricity stored in the battery is partially being utilized.

The vehicle using the power of the battery may be unsuitable for a long journey since a capacity of the battery currently being utilized lacks sufficient volume. For example, in order to utilize the vehicle using the electricity of the battery in a domestic environment, the vehicle may need to travel from Seoul to Busan, for example, about 400 kilometers (km), on a single charge. However, in order to implement such a vehicle using a conventional technology, an increase in a weight of a battery may be inevitable, and correspondingly decrease an efficiency of the electric vehicle. In addition, although the internal combustion engine vehicle may make a relatively short stop at a gas station to refuel, the electric vehicle using the power of the battery may require a relatively long time to re-charge the battery. Accordingly, refueling of the electric vehicle in a short time may be difficult, when compared to the internal combustion engine vehicle.

In this regard, Korean Patent No. 0940240, registered in the name of the present applicant, discloses a transportation system using an automobile receiving electricity from an electricity supply device installed below a surface of a road. An online electric vehicle (OLEV) described in the disclosure may receive electricity supplied from an electricity supply device installed underground, and operate a motor for driving wheels using the supplied electricity. When the OLEV travels on a road where a current supply device is installed, the OLEV may be driven using the electricity supplied from the electricity supply device. When the OLEV travels on a road where the current supply device is not installed, the OLEV may be driven using electricity stored in the battery. In addition, the supplied electricity may be used for charging the battery of the OLEV. Accordingly, mounting a heavy battery of a large capacity for a long distance trip may be unnecessary and thus, an efficiency of the OLEV may increase. In addition, the OLEV may not need to stop for a long time to charge the battery since the battery may be charged while the OLEV is driven along the road where the current supply device is installed.

A current supply device for supplying power to the OLEV may include a W-type current supply device disclosed in Korean Patent Application No. 10-2009-0067715, filed in the name of the present applicant, and an 1-type current supply device disclosed in Korean Patent Application No. 10-2009-0091802, filed in the name of the present applicant. Korean Patent Application No. 10-2009-0067715 discloses a W-type current supply device or a dual rail-type current supply device in which electrodes may be arranged in a moving direction of an automobile, in particular, in a direction orthogonal to a direction in which a road extends, and current supply cables may extend along the moving direction of the automobile. In contrast, Korean Patent Application No. 10-2009-0091802 discloses the I-type current supply device in which electrodes may be arranged along a moving direction of an automobile. In addition to the two types of the current supply device described above, a U-type or a mono rail-type current supply device may be implemented. In the W-type current supply device, electrodes may be disposed on both sides and in a center. In the U-type current supply device, electrodes may be disposed on both sides.

Disclosure of Invention

Technical Goals

An aspect of the present invention provides a method and device for designing various types of a current supply and collection device readily and systematically.

Technical solutions

According to an aspect of the present invention, there is provided a method of designing a current supply device for supplying power wirelessly to a vehicle including a current collection device, the method including operations of (a) receiving an input of a gap between the current supply device and the current collection device, (b) determining either a width of a current supply and collection core or a gap between two adjacent magnetic poles of the current supply device, based on the gap between the current supply device and the current collection device, (c) receiving an input of a value required for a magnitude of a magnetic field occurring in the current supply device, and (d) determining an amount of power to be supplied to the current supply device, based on either of the width of the current supply and collection core or the gap between the two adjacent magnetic poles of the current supply device determined in the operation (b), and the value required for the magnitude of the magnetic field.

The operations may further include (d1) determining a method of disposing an electric cable to be used for supplying the power to the current supply device after the operation (d) is performed.

The operations may further include receiving an input of an arrangement direction of magnetic poles of the current supply device before the operation (a) is performed.

The arrangement direction of the magnetic poles of the current supply device may indicate that at least two magnetic poles may extend in a direction parallel to a moving direction of the vehicle and may be aligned with each other.

The arrangement direction of the magnetic poles of the current supply device may indicate that a plurality of magnetic poles may be arranged in series along a moving direction of the vehicle.

The operations may further include (d2) determining an active or passive shielding scheme with respect to an electromagnetic field (EMF) occurring in the current supply device and the current collection device after the operation (d) is performed.

The operations may further include (d3) determining an ON and OFF state of a switch of the current supply device after the operation (d) is performed.

The operations may further include (d4) determining to resonate the current collection device attached to the vehicle at a frequency of an alternating current magnetic field occurring in the current supply device after the operation (d) is performed.

According to another aspect of the present invention, there is provided a method of designing a current collection device and a current supply device for supplying power wirelessly to a vehicle including a current collection device by generating a magnetic field, the method including operations of (a) setting a design parameter to an initial value, the design parameter including a resonant frequency, a feed current value, a width of a current supply and collection core, and a winding number of a current collection coil, (b) receiving an input of a minimum current collecting capacity value required by the current collection device, hereinafter referred to as "the current collecting capacity reference value," and a maximum EMF value allowed to occur in the current supply device and the current collection device, hereinafter referred to as "the EMF reference value," (c) calculating a current collecting capacity and a level of an occurring EMF from a design parameter currently being set, (d) repeating the calculating of the current collecting capacity and the level of the occurring EMF while adjusting the feed current value of the set design parameter when the calculated current collecting capacity is less than the current collecting capacity reference value or when the calculated level of the occurring EMF is greater than the EMF reference value, hereinafter referred to as "fails to satisfy a design condition," and (e) determining a feed current value and another design parameter currently being set, to be a final design parameter when the feed current value enabling the calculated current collecting capacity to be greater than or equal to the current collecting capacity reference value and the level of the occurring EMF to be less than or equal to the EMF reference value, hereinafter referred to as "to satisfy the design condition," is present.

When the feed current value satisfying the design condition is present in the operation (e), the operations may further include, before a design parameter currently being set is determined to be the final design parameter, (e11) obtaining a maximum resonant frequency, hereinafter referred to as "the upper limit resonant frequency," satisfying the design condition by repeating the calculating of the current collecting capacity and the level of the occurring EMF while increasing the resonant frequency of the design parameter within a range lower than the upper limit resonant frequency, when a resonant frequency value currently being set is less than the upper limit resonant frequency within an allowable range, and (e12) determining the maximum resonant frequency determined in the operation (e11), the feed current value of the operation (e), and the other design parameter currently being set, to be the final design parameter.

When the feed current value satisfying the design condition is absent in the operation (e), the operations may further include, before a design parameter currently being set is determined to be the final design parameter, (e21) repeating the calculating of the current collecting capacity and the level of the occurring EMF while increasing the width of the current supply and collection core or a gap between magnetic poles, hereinafter commonly referred to as "the width of the current supply and collection core," within an allowable range and adjusting a feed current value, (e22) terminating a process of designing the current supply device and the current collection device when a width of the current supply and collection core and a feed current value satisfying the design condition are absent, or proceeding with operation (e23) when the width of the current supply and collection core and the feed current value satisfying the design condition are present, (e23) obtaining an upper limit resonant frequency satisfying the design condition by repeating the calculating of the current collecting capacity and the level of the occurring EMF while increasing the resonant frequency of the design parameter within a range lower than the upper limit resonant frequency, when a resonant frequency value currently being set is less than the upper limit resonant frequency within an allowable range, and (e24) determining the upper limit resonant frequency determined in the operation (e23), the feed current value of the operation (e22), and the other design parameter currently being set, to be the final design parameter.

The design parameter adjusted in the operation (d) may include a winding number of the current collection coil, and the design parameter determined to be the final design parameter in the operation (e) may include a winding number of the current collection coil.

The resonant frequency value may be determined to be a value greater than a maximum audible frequency value.

A determination as to whether the design condition is satisfied may include determining whether a distance between the current supply device and the current collection device is greater than or equal to a predetermined minimum distance.

According to still another aspect of the present invention, there is provided a method of designing a current supply device for supplying power wirelessly to a vehicle including a current collection device by generating a magnetic field, the method including operations of (a) receiving an input of a core structure type of the current supply device and the current collection device to determine a design parameter including a resonant frequency, a feed current value, a width of a current supply and collection core, and a winding number of a current collection coil, (b) setting the design parameter to an initial value, (c) receiving an input of a minimum current collecting capacity value required by the current collection device, hereinafter referred to as "the current collecting capacity reference value," and a maximum EMF value allowed to occur in the current supply device and the current collection device, hereinafter referred to as "the EMF reference value," (d) calculating a current collecting capacity value and a level of an occurring EMF from a design parameter currently being set, (e) repeating the calculating of the current collecting capacity and the level of the occurring EMF while adjusting the feed current value of the set design parameter when the calculated current collecting capacity is less than the current collecting capacity reference value or when the calculated level of the occurring EMF is greater than the EMF reference value, hereinafter referred to as "fails to satisfy a design condition," and (f) determining a feed current value and another design parameter currently being set, to be a final design parameter with respect to the core structure type, when the feed current value enabling the calculated current collecting capacity to be greater than or equal to the current collecting capacity reference value and the level of the occurring EMF to be less than or equal to the EMF reference value, hereinafter referred to as "to satisfy the design condition," is present.

When at least two core structure types are input in the operation (a), the operations (b) through (f) may be performed sequentially with respect to each core structure type.

When the feed current value satisfying the design condition is present in the operation (f), the operations may further include, before a design parameter currently being set is determined to be the final design parameter, (f11) obtaining a maximum resonant frequency, hereinafter referred to as "the upper limit resonant frequency," satisfying the design condition by repeating the calculating of the current collecting capacity and the level of the occurring EMF while increasing the resonant frequency of the design parameter within a range lower than the upper limit resonant frequency, when a resonant frequency value currently being set is less than the upper limit resonant frequency within an allowable range, and (f12) determining the maximum resonant frequency determined in the operation (f11), the feed current value of the operation (f), and the other design parameter currently being set, to be the final design parameter.

When the feed current value satisfying the design condition is absent in the operation (f), the operations may further include, before a design parameter currently being set is determined to be the final design parameter, (f21) repeating the calculating of the current collecting capacity and the level of the occurring EMF while increasing the width of the current supply and collection core or a gap between magnetic poles, hereinafter commonly referred to as "the width of the current supply and collection core," within an allowable range and adjusting a feed current value, (f22) terminating a process of designing the current supply device when a width of the current supply and collection core and a feed current value satisfying the design condition are absent, or proceeding with operation (f23) when the width of the current supply and collection core and the feed current value satisfying the design condition are present, (f23) obtaining an upper limit resonant frequency satisfying the design condition by repeating the calculating of the current collecting capacity and the level of the occurring EMF while increasing the resonant frequency of the design parameter within a range lower than the upper limit resonant frequency, when a resonant frequency value currently being set is less than the upper limit resonant frequency within an allowable range, and (f24) determining the upper limit resonant frequency determined in the operation (f23), the feed current value of the operation (f22), and the other design parameter currently being set, to be the final design parameter.

The design parameter adjusted in the operation (e) may include a winding number of the current collection coil, and the design parameter determined to be the final design parameter in the operation (f) may include a winding number of the current collection coil.

The resonant frequency value may be determined to be a value greater than a maximum audible frequency value.

A determination as to whether the design condition is satisfied may include determining whether a distance between the current supply device and the current collection device is greater than or equal to a predetermined minimum distance.

According to yet another aspect of the present invention, there is provided a device for designing a current collection device and a current supply device for supplying power wirelessly to a vehicle including a current collection device by generating a magnetic field, the device including a current collecting capacity calculating unit to calculate a current collecting capacity from a design parameter including a resonant frequency, a feed current value, a width of a current supply and collection core, and a winding number of a current collection coil, an EMF level calculating unit to calculate a level of an occurring EMF from the design parameter, a design parameter database to store the design parameter and a variable range value of the design parameter, an input unit to receive, from a user, an input of the design parameter, the variable range value of the design parameter, and a design condition reference value including a requested current collecting capacity and a requested level of the EMF, a design page providing unit to display a variety of data of a design process, the data including data calculated during the design process, the design condition reference value, and the design parameter value, and a design process controlling unit to control the calculating of the current collecting capacity and the level of the EMF according to a change in the design parameter, and a process of determining a design parameter based on a result of the calculating by controlling the aforementioned elements, in order to design the current supply device and the current collection device satisfying a current collecting capacity and a level of an EMF within a predetermined range.

The design parameter may include a core structure type of the current supply device and the current collection device.

The design condition reference value may include a minimum distance value between the current supply device and the current collection device.

The device may further include a distance calculating unit to calculate a distance between the current supply device and a current collection device from the design parameter.

Advantageous effects

According to embodiments of the present invention, functional requirements may be decoupled in a method of designing an online electric vehicle and thus, a current supply device may be designed readily.

In addition, in the designing method, various types of a current supply and collection device may be designed using an optimal method.

Brief Description of Drawings

FIG. 1 is a diagram illustrating a length direction and a width direction of an online electric vehicle.
FIG. 2 is a diagram illustrating a U-type current supply device.
FIG. 3 is a diagram illustrating an I-type current supply device.
FIG. 4 is a flowchart illustrating a method of designing a current supply device based on an axiomatic design theory.
FIG. 5 is a flowchart illustrating a method for an optimal design of a current supply and collection device.
FIG. 6 is a diagram illustrating a device for designing a current supply and collection device for supplying and collecting power using a magnetic induction scheme.

<Description on reference numerals >

100: Online electric vehicle
10, 20: Current supply device
200: U-type current supply device
211: Core (magnetic pole) of U-type current supply device
212: Current supply cable of U-type current supply device
213: Cross section of U-type current supply device
300: I-type current supply device
311: Core (magnetic pole) of I-type current supply device
312, 313: Current supply cable of I-type current supply device

250, 350: Magnetic field formed by current supply device
600: Device for designing current supply device
610: Design process controlling unit
620: Current collecting capacity calculating unit
630: EMF level calculating unit
640: Distance calculating unit
650: Design parameter database
660: Input unit
670: Design page providing unit

Best Mode for Carrying Out the Invention

Reference will now be made in detail to embodiments of the present invention, examples of which are illustrated in the accompanying drawings, wherein like reference numerals refer to the like elements throughout. The embodiments are described below in order to explain the present invention by referring to the figures. The terms or words used in the description and claims should not be interpreted on a conventional or dictionary basis, but should be interpreted on a meaning and concept basis well matching with the technical concepts of the present invention with the principle that the inventor(s) can properly define the concepts of the terms to explain his or her own invention in the best manner. The embodiments disclosed herein and the configurations shown in the drawings are only the preferred embodiments of the present invention, not expressing the technical concepts of the present invention, so it should be interpreted that there are various alternative equivalents and modifications at the time the application is made.

With respect to a design method according to embodiments of the present invention, design parameters of a transportation system using an online electric vehicle (OLEV) may be determined as follows based on an axiomatic design theory.

Functional requirements (FRs) of the transportation system are as follows:

FR1 = Propel the vehicle with electric power
FR2 = Transfer electricity from underground electric cable to the vehicle
FR3 = Steer the vehicle
FR4 = Brake the vehicle
FR5 = Reverse the direction of motion
FR6 = Change the vehicle speed
FR7 = Provide the electric power when there is no external electric power supply
FR8 = Supply electric power to the underground cable

Constraints (Cs) of the transportation system are as follows:

C1 = Safety regulations governing electric systems
C2 = Price of OLEV (should be competitive with cars with IC engines)
C3 = No emission of greenhouse gases
C4 = Long-term durability and reliability of the system
C5 = Vehicle regulation for space clearance between the road and the bottom of the vehicle

Design parameters (DPs) of the transportation system satisfying the aforementioned FRs and Cs are as follows:

DP1 = Electric motor
DP2 = Underground coil
DP3 = Conventional steering system
DP4 = Conventional braking system
DP5 = Electric polarity
DP6 = Motor drive
DP7 = Re-chargeable battery
DP8 = Electric power supply system

Eight FRs and eight DPs of the transportation system are provided above. In addition, a design matrix may be uncoupled. However, the FRs and the DPs of the transportation system may be decomposed until a detailed design is completed.

Herein, a method of designing a current supply device to be used in the transportation system may be provided by decomposing the second FR, hereinafter referred to as "FR2," and the second DP, hereinafter referred to as "DP2," of the transportation system. FR2 and DP2 may be rewritten as follows:

FR2 = Transfer electricity from underground electric cable to the vehicle
DP2 = Underground coil

Since a detailed design concept is absent, FR2 and DP2 may not be implemented intactly. Accordingly, an intact concept on the OLEV may be defined by considering FRs and DPs of a lower level. Hereinafter, by decomposing the FRs and DPs to a lower level, 1) a method of transferring power above a ground, and a method of adjusting a maximum height of a current collection device, in particular, a method of adjusting a gap between the ground and the current collection device installed in a vehicle, may be described.

FR2 may be decomposed as follows:

FR21 = Generate an alternating magnetic field
FR22 = Control the power level of the magnetic field
FR23 = Shape the magnetic field to control the height of the field, H
FR24 = Control the radiation (EMF)
FR25 = On/Off the magnetic field
FR26 = Maximize the pick-up of the power in the alternating magnetic field created under the ground for use in the vehicle

Various other methods may satisfy the aforementioned FRs. Herein, in order to implement an uncoupled design, DPs may be selected as follows:

DP21 = Underground power lines with AC field surrounding the magnetic core (ferrite)
DP22 = Electric power level, i.e., current (I) times voltage (V)
DP23 = Width of the magnetic poles established by the magnetic core in the ground
DP24 = Active or passive shield for EMF
DP25 = Switch that turn on/off the underground power
DP26 = Pick-up unit mounted on the car that resonates the frequency of the alternating magnetic field

When the FRs and DPs are set as described above, a design matrix may be provided as expressed in Equation 1.

[Equation 1]

$$\begin{pmatrix} FR21 \\ FR22 \\ FR23 \\ FR24 \\ FR25 \\ FR26 \end{pmatrix} = \begin{pmatrix} A11 & A12 & A13 & 0 & 0 & 0 \\ 0 & A22 & A23 & 0 & 0 & 0 \\ 0 & 0 & A33 & 0 & 0 & 0 \\ 0 & 0 & 0 & A44 & 0 & 0 \\ 0 & 0 & 0 & 0 & A55 & 0 \\ 0 & 0 & 0 & 0 & 0 & A66 \end{pmatrix} \begin{pmatrix} DP21 \\ DP22 \\ DP23 \\ DP24 \\ DP25 \\ DP26 \end{pmatrix}$$

In Equation 1, A11, A12, and the like may be provided as a constant function (a case of a linear system) or a DP function (a case of a non-linear system), and denote a relationship between FRs and DPs. As understood from Equation 1, FR21 may be related to DP21, DP22, and DP23, FR22 may be related to DP22 and DP23, and FR23 may be related to DP23.

From Equation 1, it may be understood that the design according to embodiments of the present invention corresponds to a decoupled design. In addition, it may also be understood that a relationship between FRs {FR24, FR25, FR26} and DPs {DP24, DP25, DP26} is uncoupled.

A relationship between FRs {FR21, FR22, FR 23} and DPs {DP21, DP22, DP23} may correspond to a triangular matrix which indicates a decoupled design. In such types of decoupled designs, DP23 may be determined first. By determining DP22 and DP21 sequentially, values of respective FRs (FR21, FR22, FR23) may be set. In particular, each FR may be determined sequentially as expressed in Equation 2.

[Equation 2]

$$FR23 = A33 \cdot DP23$$

$$FR22 = A22 \cdot DP22 + A23 \cdot DP23$$

$$FR21 = A11 \cdot DP21 + A12 \cdot DP22 + A13 \cdot DP23$$

When the sequence shown in Equation 2 is not followed, independent determination of FRs may not be possible. Since FR24 and FR25 are uncoupled, FR24 and FR25 may be determined independently, as expressed in Equation 3.

[Equation 3]

$$FR24 = A44 \cdot DP24$$

$$FR25 = A55 \cdot DP25$$

$$FR26 = A66 \cdot DP26$$

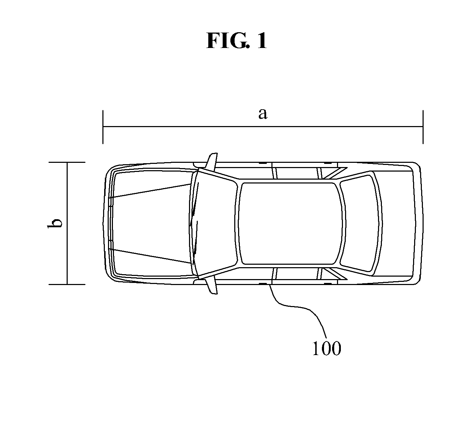

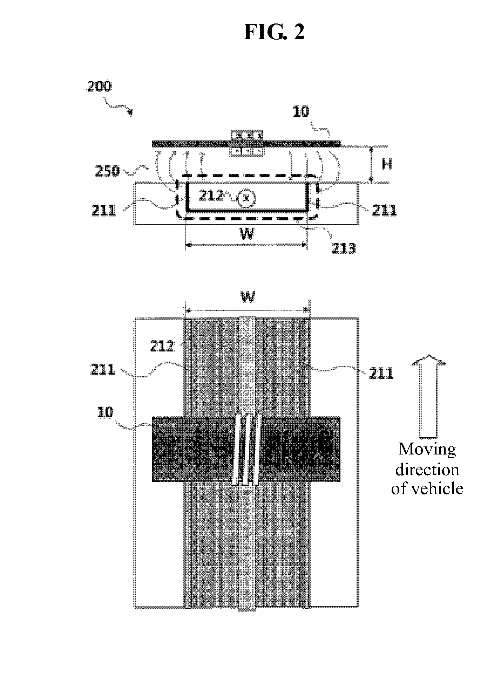

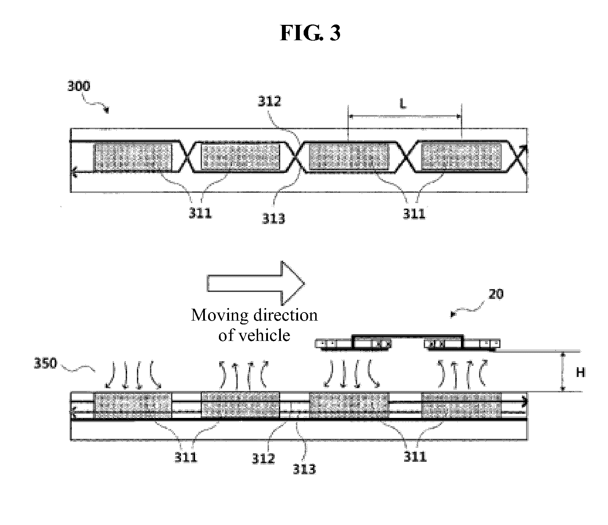

Hereinafter, the design method described above will be described in detail with reference to FIGS. 1 through 3 in relation to embodiments applied to a method of designing a U-type current supply device, and a method of designing an I-type current supply device, respectively. In FIG. 1, a denotes a length of a vehicle, and b denotes a width of the vehicle. FIGS. 2 and 3, W denotes a width of a core, for example, a magnetic pole, in a case of the U-type current supply device, and L denotes a gap between cores in a case of the I-type current supply device.

In a case of the U-type current supply device, a gap H between the ground and the current collection device may be adjusted by setting a core width W. This may be expressed by: FR23 = H = (Constant) x f(W). Here, f(W) denotes a function of the core width W. In order to satisfy FR22, in particular, in order to adjust a level of a magnetic force of a magnetic field, a level of power, in particular, current and voltage may be determined. For example, when the voltage is determined, the current may be set. FR21 may be affected by DP22 and DP23, and may be adjusted by DP21. For example, a number of electric cables to be installed underground along a moving direction of a vehicle may correspond to DP21.

When the description provided above is applied to Equation 1, a relationship as expressed in Equation 4 may be obtained.

[Equation 4]

$$FR23 = A33 \cdot DP23 = A33 \times f(W)$$

$$FR22 = A22 \cdot DP22 + A23 \cdot DP23 = A22 \cdot I \cdot V + A23 \times f(W)$$

$$FR21 - A11 \cdot DP21 + A12 \cdot DP22 + A13 \cdot DP23$$

$$= A11 \cdot \text{electromagnet design} + A12 \cdot I \cdot V + A13 \times f(W)$$

In a case of the I-type current supply device, a relationship identical to the relationship for the U-type current supply device may be applied. However, in the case of the I-type current supply device, FR23 may be expressed using a function of a core gap L with respect to a moving direction of a vehicle.

Since cores, for example, magnetic poles, may be arranged along a moving direction of the vehicle, the I-type current supply device may have advantages as follows:

1) Since a length a of the vehicle is greater than a width b of the vehicle, when the I-type current supply device is used, the gap between the magnetic poles may be set to be greater along a length direction of the vehicle, for example, the moving direction of the vehicle. In addition, as the gap between the magnetic poles increases, the gap H between the ground and the current supply device of the vehicle may increase.

2) By disposing magnetic poles in a direction identical to the moving direction of the vehicle, a magnetic field may be formed to be narrow with respect to a width direction of the vehicle. Accordingly, shielding of the magnetic field in the width direction of the vehicle may be favorable.

3) By providing a plurality of magnetic fields simultaneously occurring along a width direction of the vehicle by additionally disposing at least one I-type current supply device in the width direction of the vehicle, an amount of power to be transmitted may be increased.

4) By flattening a profile of a magnetic field by introducing a phase delay between electric cables disposed along the moving direction of the vehicle, an efficiency of power transmission may be increased.

Hereinafter, based on the descriptions provided above, a method of designing a current supply device for supplying power wirelessly to a vehicle including a current collection device according to embodiments of the present invention will be described.

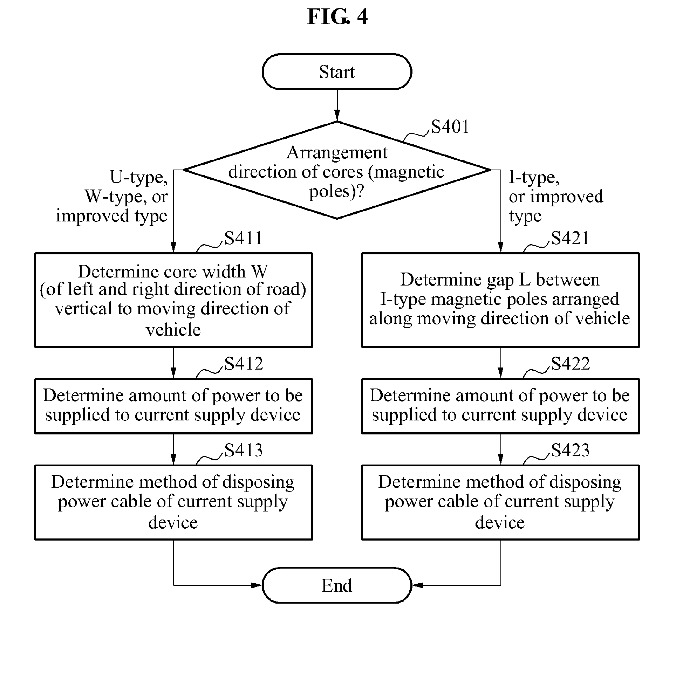

FIG. 4 is a flowchart illustrating a method of designing a current supply device based on an axiomatic design theory.

First, a type of the current supply device may be input. In particular, a selection regarding whether the type of the current supply device corresponds to a U-type, a W-type, an I-type, or an improved type of each of the U-type, the W-type, and the I-type may be input in operation S401.

The U-type current supply device may have a core structure as shown in FIG. 2, in which at least two magnetic poles 211 extend in a direction parallel to a moving direction of a vehicle and are aligned with each other. Since a cross section 213 of a core, the cross section 213 (of a left and right direction) vertical to the moving direction of the vehicle, is provided in a "U"-shaped form, the current supply device may be called the U-type current supply device.

The I-type current supply device may have a core structure as shown in FIG. 3, in which a plurality of magnetic poles 311 is arranged in series along the moving direction of the vehicle such that a single column or a plurality of columns is formed in series along the moving direction of the vehicle. Since a cross section of magnetic poles, the cross section vertical to the moving direction of the vehicle, is provided in an "I"-shaped form, the current supply device may be called the I-type current supply device.

The W-type current supply device may have a structure similar to a structure of the U-type current supply device in which current supply cores are disposed to be parallel and adjacent to the moving direction of the vehicle. Accordingly, since a cross section of magnetic poles, the cross section (of a left and right direction) vertical to the moving direction of the vehicle, is provided in a "W"-shaped form, the current supply device may be called the W-type current supply device.

Furthermore, there may be various types of the core structure partially modified and improved from the I-type, U-type, and W-type current supply device.

When the type of the current supply device is determined, a gap H between a current supply device and a current collection device (see FIGS. 2 and 3) may be input. The current supply device may be installed underground, and an upper portion of the core may be almost identical to the ground. Accordingly, a gap between the ground and the current collection device may be input. In operation S411 or S421, a gap between two adjacent magnetic poles of the current supply device may be determined based on the gap between the current supply device and the current collection device. In particular, in a case of the U-type current supply device, the W-type current supply device, or the improved type current supply device of each of the U-type current supply device and the W-type current supply device, a width W (see FIG. 2) of a core, for example, a magnetic pole vertical to the moving direction of the vehicle, in particular, with respect to a left and right direction while viewing the road ahead may be determined in operation S411. In a case of the I-type current supply device or the improved type current supply device of the I-type current supply device, a gap L (See FIG. 3) between I-type cores, for example, magnetic poles, arranged in series along the moving direction of the vehicle may be determined in operation S421.

When the gap between the current supply device and the current collection device is determined, a value required with respect to a magnitude of a magnetic field occurring in the current supply device may be input. The magnitude of the magnetic field may be determined based on an amount of power to be used for driving the vehicle, an efficiency of power transmission between the current supply device and the current collection device, and the like. In operation S412 or S422, an amount of power to be supplied to the current supply device may be determined based on the determined gap between the current supply device and the current collection device, and the value required with respect to the magnitude of the magnetic field. For example, when a voltage level is determined, a level of current to be supplied may be determined.

In operation S413 or S423, a method of disposing electric cables for supplying power to the current supply device may be determined. For example, a diameter of the electric cables, a number of the electric cables, and the like may be determined.

In the design method according to the axiomatic design theory described above, a relationship between FRs and DPs may be decoupled or uncoupled and thus, a current supply device for an OLEV may be designed readily.

Hereinafter, an optimal method of designing an OLEV derived from the design method according to the axiomatic design theory will be described.

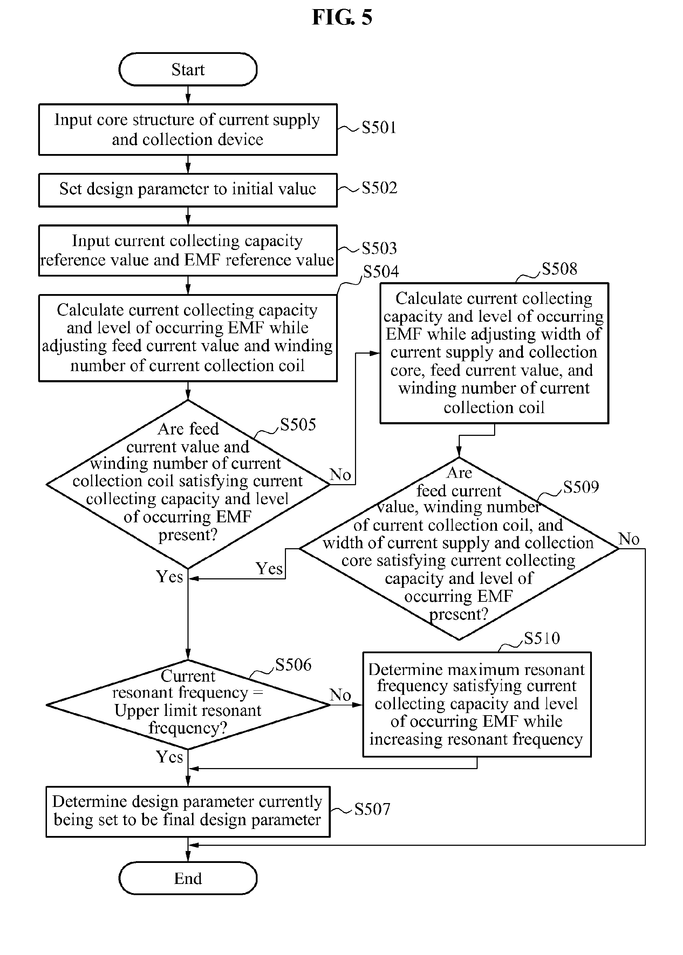

FIG. 5 is a flowchart illustrating a method for an optimal design of a current supply and collection device.

An object of the optimal design may correspond to maximizing a current collecting capacity. When $P_c$ denotes a current collecting capacity, and $V_c$ denotes a current collecting voltage, $P_c$ may be proportional to the square of $V_c$.

That is, $P_c \propto V_c^2$ may be completed.

The current collecting voltage may be expressed using a function of parameters related to the current collecting voltage, as $V_c = F(f_r, I_s, N_1, N_2, g_{air}, W_c, S_c, C_c)$. Here, the parameters include $f_r$ denoting a resonant frequency, $I_s$ denoting a feed current, $N_1$ denoting a winding number of a coil of a primary side (the current supply device), $N_2$ denoting a winding number of a coil of a secondary side (the current collection device), $g_{air}$ denoting a distance between the current supply device and the current collection device, $W_c$ denoting a width of a current supply and collection core, for example, a gap between magnetic poles in a case of the I-type, $S_c$ denoting a current supply and collection core structure, for example, the U-type, the W-type, the I-type, and the improved type, and $C_c$ denoting a material characteristic of a current supply and collection core, for example, a permeability and a frequency characteristic. $V_c$ may be proportional to the following equation.

$$V_c \propto \frac{f_r I_s N_2 W_c}{N_1 g_{air}}$$

Another object of the optimal design may correspond to maximizing a current collecting efficiency. The efficiency E may satisfy the following equation.

$$E = \frac{RegulatorOutputPower}{CurrentSupplyInverterInputPower} = \frac{CurrentCollectingCapacity}{CurrentSupplyLineCapacity} = \frac{P_c}{P_s} = \frac{\frac{V_c^2}{R_c}}{I_s^2 R_s} = \frac{V_c^2}{R_c I_s^2 R_s}$$

Here, $R_c$ denotes a current collecting resistance, $R_s$ denotes a current supply line resistance (a current supply line valid cross-sectional area, a resonant frequency function, a line length, and a conductivity).

In designing of the current supply device, the distance $g_{air}$ may be proportional to the following Equation.

$$g_{air} = F(f_r, I_s, \frac{N_2}{N_1}, W_c, S_c, C_c) \propto f_r I_s \frac{N_2}{N_1} W_c$$

For example, maintaining $g_{air}$ to be greater than or equal to 12 centimeters (cm) may be necessary for a case of a sedan, and 20 cm for a case of a large-sized vehicle such as, a bus and the like.

A level of an occurring EMF may need to be less than a predetermined value. In particular, when the level of the occurring EMF corresponds to $L_{emf}$,

$$L_{emf} = F(f_r, I_s, \frac{N_2}{N_1}, W_c, S_c, C_c, g_{air}) \propto f_r I_s \frac{N_2}{N_1} W_c \cdot g_{air}$$ may be completed. In this instance, maximum $L_{emf} < 62.5$ milligauss (mG) (passive, LC resonant coil type, active shielding) may need to be satisfied at a predetermined point.

Referring to FIG. 5, in operation S501, a type of a core structure of the current supply and collection device to determine a design parameter including a resonant frequency, a feed current value, a width of a current supply and collection core, and a winding number of a current collection coil may be input. The type of the current supply core structure may include an I-type, a U-type, a W-type, and a type improved by a partial modification of each of the I-type, the U-type, and the W-type. The type of the current supply core structure is described above with reference to FIGS. 2 through 4.

In operation S502, the design parameter may be set to an initial value. The design parameter may include various parameters in addition to the aforementioned parameters. In operation S503, a minimum current collecting capacity value required by the current collection device, hereinafter referred to as "the current collecting capacity reference value," and a maximum EMF value allowed to occur in the current supply and collection device, hereinafter referred to as "the EMF reference value" may be input. The input value may further include a minimum distance value between the current supply device and the current collection device.

In operation S504, a current collecting capacity and a level of an occurring EMF may be calculated from a design parameter currently being set, and the calculating of the current collecting capacity and the level of the occurring EMF may be repeated while adjusting the feed current value of the set design parameter when the calculated current collecting capacity is less than the current collecting capacity reference value or when the calculated level of the occurring EMF is greater than the EMF reference value, hereinafter referred to as "fails to satisfy a design condition." The adjusted design parameter may further include a winding number of the current collection coil.

In operation S505, whether a feed current value enabling the calculated current collecting capacity to be greater than or equal to the current collecting capacity reference value and the level of the occurring EMF to be less than or equal to the EMF reference value, hereinafter referred to as "to satisfy the design condition," is present may be determined. In this instance, whether a winding number of the current collection coil satisfying the design condition is present may also be determined, in operation S505. In addition, although not shown in the flowchart of FIG. 5, the determination as to whether the design condition is satisfied may further include a determination as to whether a distance between the current supply device and the current collection device is greater than or equal to a predetermined minimum distance. The further determination may be applied identically for determining whether all of the following design conditions are satisfied. The minimum distance may be set to 12 cm for a case of a sedan, and set to 20 cm for a case of a large-sized vehicle such as a bus, and the like.

In operation 570, when such values are present, the feed current value, the winding number of the current collection coil, and another design parameter currently being set may be determined to be a final design parameter with respect to the core structure type. In addition, before the determining is performed, when the resonant frequency value currently being set, among the design parameters, is less than a maximum resonant frequency, hereinafter referred to as "the upper limit resonant frequency" within an allowable range in operation S506, the upper limit resonant frequency satisfying the design condition may be obtained by repeating the calculating of the current collecting capacity and the level of the occurring EMF while increasing the resonant frequency of the design parameter within a range lower than the upper limit resonant frequency, in operation S510, and the upper limit resonant frequency, the feed current value, the winding number of the current collection coil, and the other design parameter currently being set may be determined to be the final design parameter, in operation S507.

When the feed current value and the winding number of the current collection coil satisfying the design condition area absent in operation S505, the width of the current supply and collection core may be increased within an allowable range.

The term "width of the current supply and collection core" is used throughout the drawings. However, hereinafter, the width of the current supply and collection core may refer to a width W (see FIG. 2) of a core, for example, a magnetic pole vertical to a moving direction of a vehicle, in particular, with respect to a left and right direction while viewing the road ahead, in the case of the U-type current supply device, the W-type current supply device, or the improved type current supply device of each of the U-type current supply device and the W-type current supply device. The width of the current supply and collection core may refer to a gap L (See FIG. 3) between I-type cores, for example, magnetic poles, arranged in series along the moving direction of the vehicle in the case of the I-type current supply device or the improved type current supply device of the I-type current supply device.

In particular, in operation S508, the calculating of the current collecting capacity and the level of the occurring EMF may be repeated while increasing the width of the current supply and collection core, and adjusting the feed current value, the winding number of current collection coil, and the like. When a width of the current supply and collection core, a feed current value, and a winding number of the current collection coil, and the like satisfying the design condition are present in operation S509, operation S506 may be performed. However, when the width of the current supply and collection core, the feed current value, the winding number of the current collection coil, and the like satisfying the design condition are absent in operation S509, the process of designing the current supply and collection device may be terminated.

When the width of the current supply and collection core, the feed current value, the winding number of the current collection coil, and the like satisfying the design condition are present in operation S509, an upper limit resonant frequency satisfying the design condition may be obtained by repeating the calculating of the current collecting capacity and the level of the occurring EMF while increasing the resonant frequency of the design parameter within a range lower than the upper limit resonant frequency in operation S510, when a resonant frequency value currently being set is less than the upper limit resonant frequency within an allowable range in operation S506, and the upper limit resonant frequency, the feed current value determined in the foregoing operations, the winding number of the current collection coil, the width of the current supply and collection core, and the other design parameter currently being set may be determined to be the final design parameter in operation S507.

The design process may be configured to be performed automatically and sequentially with respect to each core structure type when at least two core structure types are input at first.

The resonant frequency value may need to be determined to be a value greater than a maximum audible frequency value, for example, 20 kilohertz (kHz).

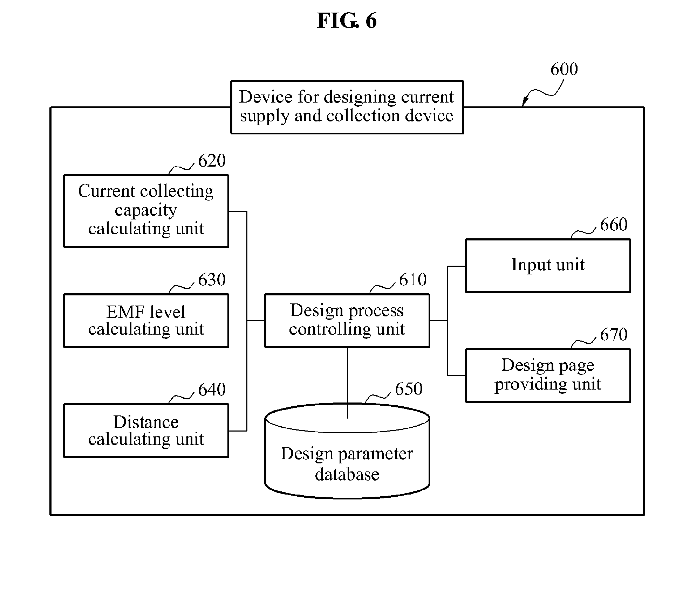

FIG. 6 is a diagram illustrating a device 600 for designing a current supply and collection device for supplying and collecting power using a magnetic induction scheme.

Referring to FIG. 6, a design process controlling unit 610 may control calculating of a current collecting capacity and a level of an EMF according to a change in each design parameter, and a process of determining a design parameter based on a result of the calculating by controlling the following elements, in order to design the current supply and collection device satisfying a current collecting capacity and a level of an EMF within a predetermined range.

A current collecting capacity calculating unit 620 may calculate a current collecting capacity from a design parameter including a resonant frequency, a feed current value, a width of a current supply and collection core, and a winding number of a current collection coil.

An EMF level calculating unit 630 may calculate a level of an occurring EMF from the design parameter.

A distance calculating unit 640 may calculate a distance between the current supply device and the current collection device from the design parameter.

A design parameter database 650 my store the design parameter and a variable range value of the design parameter.

An input unit 660 may receive, from a user, an input of the design parameter, the variable range value of the design parameter, and a design condition reference value including a requested current collecting capacity, a requested level of the EMF, and a requested minimum distance value between the current supply device and the current collection device.

A design page providing unit 670 may display a variety of data of a design process, the data including data calculated during the design process, the design condition reference value, and a design parameter value to be determined. As described above, the data calculated during the design process may include a current collecting capacity calculated by a current design parameter, a level of an occurring EMF calculated by the current design parameter, a distance between the current supply device and the current collection device calculated by the current design parameter, and the like.

**Claims**

1.  A method of designing a current supply device for supplying power wirelessly to a vehicle including a current collection device, the method comprising operations of:

    (a) receiving an input of a gap between the current supply device and the current collection device;

    (b) determining either a width of a current supply and collection core or a gap between two adjacent magnetic poles of the current supply device, based on the gap between the current supply device and the current collection device;

    (c) receiving an input of a value required for a magnitude of a magnetic field occurring in the current supply device; and

    (d) determining an amount of power to be supplied to the current supply device, based on either of the width of the current supply and collection core or the gap between the two adjacent magnetic poles of the current supply device determined in the operation (b), and the value required for the magnitude of the magnetic field.

2.  The method of claim 1, wherein the operations further comprise:

    (d1) determining a method of disposing an electric cable to be used for supplying the power to the current supply device after the operation (d) is performed.

3. The method of claim 1, wherein the operations further comprise:

   receiving an input of an arrangement direction of magnetic poles of the current supply device before the operation (a) is performed.

4. The method of claim 3, wherein the arrangement direction of the magnetic poles of the current supply device indicates that at least two magnetic poles extend in a direction parallel to a moving direction of the vehicle and are aligned with each other.

5. The method of claim 3, wherein the arrangement direction of the magnetic poles of the current supply device indicates that a plurality of magnetic poles is arranged in series along a moving direction of the vehicle.

6. The method of claim 1, wherein the operations further comprise:

   (d2) determining an active or passive shielding scheme with respect to an electromagnetic field (EMF) occurring in the current supply device and the current collection device after the operation (d) is performed.

7. The method of claim 1, wherein the operations further comprise:

   (d3) determining an ON and OFF state of a switch of the current supply device after the operation (d) is performed.

8. The method of claim 1, wherein the operations further comprise:

   (d4) determining to resonate the current collection device attached to the vehicle at a frequency of an alternating current magnetic field occurring in the current supply device after the operation (d) is performed.

9. A method of designing a current collection device and a current supply device for supplying power wirelessly to a vehicle including a current collection device by generating a magnetic field, the method comprising operations of:

   (a) setting a design parameter to an initial value, the design parameter comprising a resonant frequency, a feed current value, a width of a current supply and collection core, and a winding number of a current collection coil;
   (b) receiving an input of a minimum current collecting capacity value required by the current collection device, hereinafter referred to as "the current collecting capacity reference value," and a maximum electromagnetic field (EMF) value allowed to occur in the current supply device and the current collection device, hereinafter referred to as "the EMF reference value";
   (c) calculating a current collecting capacity and a level of an occurring EMF from a design parameter currently being set;
   (d) repeating the calculating of the current collecting capacity and the level of the occurring EMF while adjusting the feed current value of the set design parameter when the calculated current collecting capacity is less than the current collecting capacity reference value or when the calculated level of the occurring EMF is greater than the EMF reference value, hereinafter referred to as "fails to satisfy a design condition"; and
   (e) determining a feed current value and another design parameter currently being set, to be a final design parameter when the feed current value enabling the calculated current collecting capacity to be greater than or equal to the current collecting capacity reference value and the level of the occurring EMF to be less than or equal to the EMF reference value, hereinafter referred to as "to satisfy the design condition," is present.

10. The method of claim 9, wherein, when the feed current value satisfying the design condition is present in the operation (e), the operations further comprise, before a design parameter currently being set is determined to be the final design parameter:

   (e11) obtaining a maximum resonant frequency, hereinafter referred to as "the upper limit resonant frequency," satisfying the design condition by repeating the calculating of the current collecting capacity and the level of the occurring EMF while increasing the resonant frequency of the design parameter within a range lower than the upper limit resonant frequency, when a resonant frequency value currently being set is less than the upper limit resonant frequency within an allowable range; and
   (e12) determining the maximum resonant frequency determined in the operation (e11), the feed current value of the operation (e), and the other design parameter currently being set, to be the final design parameter.

11. The method of claim 9, wherein, when the feed current value satisfying the design condition is absent in the operation (e), the operations further comprise, before a design parameter currently being set is determined to be the final design parameter:

(e21) repeating the calculating of the current collecting capacity and the level of the occurring EMF while increasing the width of the current supply and collection core or a gap between magnetic poles, hereinafter commonly referred to as "the width of the current supply and collection core," within an allowable range and adjusting a feed current value;
(e22) terminating a process of designing the current supply device and the current collection device when a width of the current supply and collection core and a feed current value satisfying the design condition are absent, or proceeding with operation (e23) when the width of the current supply and collection core and the feed current value satisfying the design condition are present;
(e23) obtaining an upper limit resonant frequency satisfying the design condition by repeating the calculating of the current collecting capacity and the level of the occurring EMF while increasing the resonant frequency of the design parameter within a range lower than the upper limit resonant frequency, when a resonant frequency value currently being set is less than the upper limit resonant frequency within an allowable range; and
(e24) determining the upper limit resonant frequency determined in the operation (e23), the feed current value of the operation (e22), and the other design parameter currently being set, to be the final design parameter.

12. The method of claim 9, wherein the design parameter adjusted in the operation (d) comprises a winding number of the current collection coil, and the design parameter determined to be the final design parameter in the operation (e) comprises a winding number of the current collection coil.

13. The method of claim 9, wherein the resonant frequency value is determined to be a value greater than a maximum audible frequency value.

14. The method of one of claims 9 to 13, wherein a determination as to whether the design condition is satisfied comprises determining whether a distance between the current supply device and the current collection device is greater than or equal to a predetermined minimum distance.

15. A method of designing a current supply device for supplying power wirelessly to a vehicle including a current collection device by generating a magnetic field, the method comprising operations of:

(a) receiving an input of a core structure type of the current supply device and the current collection device to determine a design parameter including a resonant frequency, a feed current value, a width of a current supply and collection core, and a winding number of a current collection coil;
(b) setting the design parameter to an initial value;
(c) receiving an input of a minimum current collecting capacity value required by the current collection device, hereinafter referred to as "the current collecting capacity reference value," and a maximum electromagnetic field (EMF) value allowed to occur in the current supply device and the current collection device, hereinafter referred to as "the EMF reference value";
(d) calculating a current collecting capacity value and a level of an occurring EMF from a design parameter currently being set;
(e) repeating the calculating of the current collecting capacity and the level of the occurring EMF while adjusting the feed current value of the set design parameter when the calculated current collecting capacity is less than the current collecting capacity reference value or when the calculated level of the occurring EMF is greater than the EMF reference value, hereinafter referred to as "fails to satisfy a design condition"; and
(f) determining a feed current value and another design parameter currently being set, to be a final design parameter with respect to the core structure type, when the feed current value enabling the calculated current collecting capacity to be greater than or equal to the current collecting capacity reference value and the level of the occurring EMF to be less than or equal to the EMF reference value, hereinafter referred to as "to satisfy the design condition," is present.

16. The method of claim 15, wherein, when at least two core structure types are input in the operation (a), the operations (b) through (f) are performed sequentially with respect to each core structure type.

17. The method of claim 15, wherein, when the feed current value satisfying the design condition is present in the operation (f), the operations further comprise, before a design parameter currently being set is determined to be the final design parameter:

(f11) obtaining a maximum resonant frequency, hereinafter referred to as "the upper limit resonant frequency," satisfying the design condition by repeating the calculating of the current collecting capacity and the level of the occurring EMF while increasing the resonant frequency of the design parameter within a range lower than the upper limit resonant frequency, when a resonant frequency value currently being set is less than the upper limit resonant frequency within an allowable range; and

(f12) determining the maximum resonant frequency determined in the operation (f11), the feed current value of the operation (f), and the other design parameter currently being set, to be the final design parameter.

18. The method of claim 15, wherein, when the feed current value satisfying the design condition is absent in the operation (f), the operations further comprise, before a design parameter currently being set is determined to be the final design parameter:

(f21) repeating the calculating of the current collecting capacity and the level of the occurring EMF while increasing the width of the current supply and collection core or a gap between magnetic poles, hereinafter commonly referred to as "the width of the current supply and collection core," within an allowable range and adjusting a feed current value;

(f22) terminating a process of designing the current supply device when a width of the current supply and collection core and a feed current value satisfying the design condition are absent, or proceeding with operation (f23) when the width of the current supply and collection core and the feed current value satisfying the design condition are present;

(f23) obtaining an upper limit resonant frequency satisfying the design condition by repeating the calculating of the current collecting capacity and the level of the occurring EMF while increasing the resonant frequency of the design parameter within a range lower than the upper limit resonant frequency, when a resonant frequency value currently being set is less than the upper limit resonant frequency within an allowable range; and

(f24) determining the upper limit resonant frequency determined in the operation (f23), the feed current value of the operation (f22), and the other design parameter currently being set, to be the final design parameter.

19. The method of claim 15, wherein the design parameter adjusted in the operation (e) comprises a winding number of the current collection coil, and the design parameter determined to be the final design parameter in the operation (f) comprises a winding number of the current collection coil.

20. The method of claim 15, wherein the resonant frequency value is determined to be a value greater than a maximum audible frequency value.

21. The method of one of claims 15 to 20, wherein a determination as to whether the design condition is satisfied comprises determining whether a distance between the current supply device and the current collection device is greater than or equal to a predetermined minimum distance.

22. A device for designing a current collection device and a current supply device for supplying power wirelessly to a vehicle including a current collection device by generating a magnetic field, the device comprising:

a current collecting capacity calculating unit to calculate a current collecting capacity from a design parameter comprising a resonant frequency, a feed current value, a width of a current supply and collection core, and a winding number of a current collection coil;

an electromagnetic field (EMF) level calculating unit to calculate a level of an occurring EMF from the design parameter;

a design parameter database to store the design parameter and a variable range value of the design parameter;

an input unit to receive, from a user, an input of the design parameter, the variable range value of the design parameter, and a design condition reference value comprising a requested current collecting capacity and a requested level of the EMF;

a design page providing unit to display a variety of data of a design process, the data comprising data calculated during the design process, the design condition reference value, and the design parameter value; and

a design process controlling unit to control the calculating of the current collecting capacity and the level of the EMF according to a change in the design parameter, and a process of determining a design parameter based on a result of the calculating by controlling the aforementioned elements, in order to design the current supply device and the current collection device satisfying a current collecting capacity and a level of an EMF within a predetermined range.

23. The device of claim 22, wherein the design parameter comprises a core structure type of the current supply device and the current collection device.

24. The device of claim 22, wherein the design condition reference value comprises a minimum distance value between the current supply device and the current collection device.

25. The device of claim 22, further comprising:

   a distance calculating unit to calculate a distance between the current supply device and a current collection device from the design parameter.

**FIG. 1**

# FIG. 2

Moving
direction
of vehicle

## FIG. 3

Moving direction
of vehicle

# FIG. 4

Start

Arrangement direction of cores (magnetic poles)? ~S401

U-type, W-type, or improved type

I-type, or improved type

~S411
Determine core width W (of left and right direction of road) vertical to moving direction of vehicle

~S421
Determine gap L between I-type magnetic poles arranged along moving direction of vehicle

~S412
Determine amount of power to be supplied to current supply device

~S422
Determine amount of power to be supplied to current supply device

~S413
Determine method of disposing power cable of current supply device

~S423
Determine method of disposing power cable of current supply device

End

## FIG. 5

Start

Input core structure of current supply and collection device — S501

Set design parameter to initial value — S502

Input current collecting capacity reference value and EMF reference value — S503

Calculate current collecting capacity and level of occurring EMF while adjusting feed current value and winding number of current collection coil — S504

Calculate current collecting capacity and level of occurring EMF while adjusting width of current supply and collection core, feed current value, and winding number of current collection coil — S508

Are feed current value and winding number of current collection coil satisfying current collecting capacity and level of occurring EMF present? — S505 — No

Are feed current value, winding number of current collection coil, and width of current supply and collection core satisfying current collecting capacity and level of occurring EMF present? — S509 — No

Yes — Yes

Current resonant frequency = Upper limit resonant frequency? — S506 — No

Determine maximum resonant frequency satisfying current collecting capacity and level of occurring EMF while increasing resonant frequency — S510

Yes

Determine design parameter currently being set to be final design parameter — S507

End

EP 2 594 425 A1

**FIG. 6**

600

Device for designing current supply and collection device

620
Current collecting capacity calculating unit

630
EMF level calculating unit

640
Distance calculating unit

610
Design process controlling unit

650
Design parameter database

660
Input unit

670
Design page providing unit

22

# EP 2 594 425 A1

## INTERNATIONAL SEARCH REPORT

| International application No. |
| --- |
| **PCT/KR2011/000867** |

| A. CLASSIFICATION OF SUBJECT MATTER |
| --- |
| ***B60L 5/00(2006.01)i, H02J 7/00(2006.01)i, H02J 17/00(2006.01)i, B60L 11/18(2006.01)i*** |
| According to International Patent Classification (IPC) or to both national classification and IPC |

| B. FIELDS SEARCHED |
| --- |
| Minimum documentation searched (classification system followed by classification symbols) <br> B60L 5/00; B60L 11/18; G06F 19/00; H02J 17/00; H02J 7/00 |
| Documentation searched other than minimum documentation to the extent that such documents are included in the fields searched <br> Korean Utility models and applications for Utility models: IPC as above <br> Japanese Utility models and applications for Utility models: IPC as above |
| Electronic data base consulted during the international search (name of data base and, where practicable, search terms used) <br> eKOMPASS (KIPO internal) & Keywords: electric vehicle, power supply, current collection, database, design |

| C. DOCUMENTS CONSIDERED TO BE RELEVANT | | |
| --- | --- | --- |
| Category* | Citation of document, with indication, where appropriate, of the relevant passages | Relevant to claim No. |
| X <br> A | US 2004-0236551 A1 (KOBAYASHI, HIDEKI et al.) 25 November 2004 <br> See abstract and figures 1-38. | 22-25 <br> 1-21 |
| A | JP 2003-189508 A (FURUKAWA ELECTRIC CO., LTD.) 04 July 2003 <br> See abstract, claim 1, figures 1-4. | 1-25 |
| A | JP 2000-092615 A (HARNESS SYST TECH RES LTD. et al.) 31 March 2000 <br> See abstract, claims 1-4. | 1-25 |
| A | KR 10-0944113 B1 (KOREA ADVANCED INSTITUTE OF SCIENCE AND TECHNOLOGY) 24 February 2010 <br> See abstract, figures 1-10. | 1-25 |

☐ Further documents are listed in the continuation of Box C. ☒ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 05 OCTOBER 2011 (05.10.2011) | **06 OCTOBER 2011 (06.10.2011)** |
| Name and mailing address of the ISA/KR <br> Korean Intellectual Property Office <br> Government Complex-Daejeon, 139 Seonsa-ro, Daejeon 302-701, Republic of Korea <br> Facsimile No. 82-42-472-7140 | Authorized officer <br><br> Telephone No. |

Form PCT/ISA/210 (second sheet) (July 2009)

INTERNATIONAL SEARCH REPORT
Information on patent family members

International application No.

**PCT/KR2011/000867**

| Patent document cited in search report | Publication date | Patent family member | Publication date |
|---|---|---|---|
| US 2004-0236551 A1 | 25.11.2004 | JP 04-064561 B2<br>JP 11-288427 A<br>US 6811344 B1<br>US 7266482 B2 | 19.03.2008<br>19.10.1999<br>02.11.2004<br>04.09.2007 |
| JP 2003-189508 A | 04.07.2003 | NONE | |
| JP 2000-092615 A | 31.03.2000 | NONE | |
| KR 10-0944113 B1 | 24.02.2010 | TW 201040049 A<br>WO 2010-098547 A2 | 16.11.2010<br>02.09.2010 |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 0940240
- KR 1020090067715
- KR 1020090091802